# EUROPÄISCHE PATENTSCHRIFT

(11) **EP 2 136 417 B1**
(45) Veröffentlichungstag und Bekanntmachung des Hinweises auf die Patenterteilung: **27.01.2016**
(21) Anmeldenummer: 09163092.1
(22) Anmeldetag: 18.06.2009
(51) Int. Cl.: H01L 41/083, H01L 41/27

(54) **Vielschichtaktor**
Multilayer actuator
Actionneur multicouche

(30) Priorität: 18.06.2008 DE 102008002495
(43) Veröffentlichungstag der Anmeldung: 23.12.2009
(73) Patentinhaber: Robert Bosch GmbH, 70442 Stuttgart (DE)
(72) Erfinder: Polster, Steffen, 70199 Stuttgart (DE); Hagemann, Benjamin, 70839 Gerlingen (DE)

(56) Entgegenhaltungen:
- WO-A1-2007/029275
- JP-A- 2006 066 901
- CARPI F ET AL: "Folded dielectric elastomer actuators", SMART MATERIALS AND STRUCTURES, Bd. 16, Nr. 2, April 2007 (2007-04), Seiten S300-S305, XP020120446, ISSN: 0964-1726

## Beschreibung

### Stand der Technik

Die Erfindung betrifft einen durch Falten eines Elektrodenstreifens herstellbaren Vielschichtaktor.

Es sind Vielschichtaktoren bekannt, die aus einem Elektrodenstreifen gefaltet sind, wobei der Elektrodenstreifen aus einer mittleren Schicht aus einem dielektrischen, deformierbaren Material besteht, auf das beidseitig Elektroden aufgebracht sind. Durch abwechselndes Falten des Elektrodenstreifens um 180° ergibt sich eine Vielschichtaktorstruktur mit einer Vielzahl von übereinander angeordneten, sich parallel zueinander erstreckenden Elektrodenabschnitten, zwischen denen dielektrisches, deformierbares Material angeordnet ist. Bei Anlegen einer elektrischen Spannung zieht sich der Vielschichtaktor in Stapelrichtung aufgrund der resultierenden elektrostatischen Anziehung der Elektrodenabschnitte zusammen. Typische Elektrodenstreifendicken liegen derzeit im Bereich von etwa 0,5 mm. Zum Erzielen einer Aktorbewegung werden elektrische Feldstärken von bis zu etwa 200 Volt/µm benötigt, weswegen geringe Schichtdicken angestrebt sind um die Steuerspannung zu minimieren.

Bekannte, zuvor beschriebene Vielschichtaktoren sind durch Falten des Elektrodenstreifens an zwei aneinander gegenüberliegenden Umfangspositionen hergestellt. Anders ausgedrückt sind die durch Falten des Elektrodenstreifens entstehenden Umbiegungen hälftig auf zwei einander gegenüberliegende Umfangspositionen verteilt angeordnet, wobei die Faltachsen der an unterschiedlichen Umfangspositionen realisierten Umbiegungen parallel zueinander verlaufen. Da die Biegeradien der Umbiegungen nicht beliebig klein ausfallen können, addieren sich die aus den Umbiegungen resultierenden, zusätzlichen Dickenerstreckungen an zwei einander gegenüberliegenden Umfangspositionen, was sich insbesondere bei Vielschichtaktoren mit mehr als 100 Faltungen nachteilig auf die Aktorgeometrie und eine mögliche Ankopplung an andere Bauteile auswirkt, insbesondere deshalb, weil der Schichtbereich zwischen den Umbiegungen vergleichsweise flach ist. Es entsteht im Bereich der Umbiegungen eine Aktorüberhöhung, da sich die Umbiegungen über die gesamte Aktorhöhe aufaddieren.

JP 2006-66901 A offenbart ein durch Falten hergestelltes Piezoelement. Insbesondere wird ein Streifen bestehend aus Elektrode/Piezomaterial/Isolator/Gegenelektrode wiederholt mittig um jeweils orthogonale Achsen gefaltet, wodurch eine Vielschichtstruktur mit Umbiegungen an allen Umfangsseiten entsteht, die als Aktor einsetzbar ist.

### Offenbarung der Erfindung

### Technische Aufgabe

Der Erfindung liegt daher die Aufgabe zugrunde, einen optimierten durch Falten eines Elektrodenstreifens hergestellten Vielschichtaktor vorzuschlagen, der im Vergleich zu bekannten Vielschichtaktoren eine verbesserte, insbesondere regelmäßigere, Aktorgeometrie aufweist.

### Technische Lösung

Diese Aufgabe wird mit einem Vielschichtaktor mit den Merkmalen des Anspruchs 1 gelöst. Vorteilhafte Weiterbildungen der Erfindung sind in den Unteransprüchen angegeben.

Der Erfindung liegt der Gedanke zugrunde, den Elektrodenstreifen nicht nur an zwei unterschiedlichen Umfangspositionen zu falten, d.h. die aus dem Faltprozess resultierenden Umbiegungen nicht nur an zwei Umfangspositionen zu stapeln, sondern mindestens drei Umfangspositionen vorzusehen, an denen Umbiegungen realisiert sind. Anders ausgedrückt liegt der Erfindung der Gedanke zugrunde, den Elektrodenstreifen an mehr als zwei Umfangspositionen zu falten, um die aus dem Falten resultierenden Umbiegungen auf mindestens drei unterschiedliche Stellen am Umfang des Vielschichtaktors zu verteilen. Hierdurch addiert sich die aus den Umbiegungen resultierende zusätzliche Materialdicke nicht nur an zwei Umfangspositionen des Vielschichtaktors in Stapelrichtung auf, sondern an drei oder mehr Positionen, wodurch negative Geometrieauswirkungen aufgrund des Übereinanderanordnens von Umbiegungen minimiert werden. Ein derartiger Vielschichtaktoraufbau ist insbesondere bei Vielschichtaktoren mit einer Vielzahl von nebeneinander angeordneten, vorzugsweise im Wesentlichen parallel zueinander verlaufenden, durch Falten des Elektrodenstreifens gebildeten Elektrodenabschnitten von Vorteil, da sich hier die Addition der zusätzlichen Materialdicke aufgrund der Vielzahl von Umbiegungen auf die Geometrie besonders negativ auswirkt.

Von besonderem Vorteil ist eine Ausführungsform, bei der die Umfangspositionen, an denen Umbiegungen des Elektrodenstreifens realisiert sind, gleichmäßig in Umfangsrichtung des Vielschichtaktors, also rund um dessen Längsachse, verteilt angeordnet sind. Auf diese Weise ist es möglich, insbesondere dann, wenn die Umbiegungen gleichmäßig auf die Umfangspositionen verteilt werden, die zusätzliche, aus dem Biegeradius der Umbiegungen resultierende Materialerhöhung gleichmäßig zu verteilen und dadurch zu ermöglichen, dass eine Überhöhung oder mehrere unmittelbar übereinander angeordnete Überhöhungen in daneben angeordnete, randseitige Bereiche ohne Überhöhungen hinragen bzw. hineinfedern können.

Besonders bevorzugt ist eine Ausführungsform, bei der die Umbiegungen, zumindest näherungsweise, gleichmäßig in Umfangsrichtung verteilt angeordnet sind. Dies kann beispielsweise auf die zuvor erwähnte Weise erfolgen, dass die Umbiegungen gleichmäßig auf gleichmäßig über den Umfang verteilte Umfangspositionen verteilt werden.

Besonders bevorzugt ist eine Ausführungsform, bei der ein Wechsel zwischen zwei in Umfangsrichtung benachbarten Umfangspositionen immer nach, zumindest näherungsweise, der gleichen Anzahl an Umbiegungen realisiert ist. Anders ausgedrückt wird die, vorzugsweise quer zu den Faltachsen orientierte, Faltrichtung bevorzugt immer nach, zumindest näherungsweise, der gleichen Anzahl an Umbiegungen bzw. Faltungen gewechselt. Eine solche Drehung der Faltrichtung kann bereits nach einem einzigen Faltvorgang oder nach einer beliebigen, vorzugsweise immer gleichen, Anzahl von Faltvorgängen erfolgen. Dabei hängt die Anzahl an Faltvorgängen, nach der ein Wechsel der Faltrichtung erfolgt, bevorzugt im Wesentlichen von der Dicke des Elektrodenstreifens und damit von der Größe der Biegeradien der Umbiegungen ab, so dass der Faltrichtungswechsel für jeden Faltaktor optimiert werden kann.

Besonders bevorzugt ist eine Ausführungsform des Vielschichtaktors, bei der die Umfangskontur des gefalteten Elektrodenstreifens die Form eines, insbesondere punktsymmetrischen, Vielecks oder eine gebogene, insbesondere kreisförmige oder ellyptische Form aufweist, wobei jeder Seitenfläche des gefalteten Elektrodenstreifens bevorzugt die gleiche Anzahl an Umbiegungen zugeordnet ist. Im Falle einer rechteckigen Konturierung des gefalteten Elektrodenstreifens sind Umbiegungen also bevorzugt an vier Umfangspositionen angeordnet, wobei die Faltachsen jeweils zweier in Umfangsrichtung benachbarter Umfangspositionen rechtwinklig zueinander angeordnet sind. Analog lassen sich die Umfangspositionen bei beliebigen n-Eck-förmigen Vielschichtaktoren verteilen.

Besonders bevorzugt ist eine Ausführungsform des Vielschichtaktors, bei der jeder Umbiegung eine Faltachse zugeordnet ist, wobei die Faltachsen von in Umfangsrichtung benachbarten Umfangspositionen einen Winkel aufspannen. Bei einer zuvor erläuterten rechteckförmigen Umfangskontur des gefalteten Elektrodenstreifens ergibt sich dabei ein Winkel von zwischen zwei in Umfangsrichtung benachbarten Umfangspositionen von 90°, bei einem sechseckigen Querschnitt von etwa 60° oder etwa 120°, etc. Besonders bevorzugt ist dabei eine Ausführungsform, bei der sämtliche Faltachsen (Schwenkachsen), zumindest näherungsweise, gleichmäßig in Umfangsrichtung des Vielschichtaktors verteilt angeordnet sind. Besonders bevorzugt ist jeder Seite einer vieleckigen Umfangskontur dabei mindestens eine Faltachse und somit eine Umbiegung zugeordnet. Besonders bevorzugt erfolgt der Wechsel der Faltachsenorientierung erst nach einer bestimmten Anzahl von Faltungen, wobei die Anzahl der Faltungen im Wesentlichen abhängig ist von der Dicke des Elektrodenstreifens und damit vom Biegeradius der Umbiegungen.

Erfindungsgemäß ist bei dem Vielschichtaktor der abgewickelte Elektrodenstreifen mäanderförmig ausgeformt, wobei der Winkel zwischen zwei benachbarten, in unterschiedliche Richtungen orientierten Elektrodenstreifenabschnitten bevorzugt abhängig ist von der Umfangskontur des gefalteten Elektrodenstreifens. So schließen bevorzugt zwei benachbarte, in unterschiedliche Richtungen orientierte, Elektrodenstreifenabschnitte bei einem rechteckig konturierten, gefalteten Elektrodenstreifen einen Winkel von 90° ein, wohingegen bei einer sechseckigen Ausführungsform des gefalteten Elektrodenstreifens zwei in unterschiedliche Richtungen orientierte Elektrodenstreifenabschnitte bevorzugt einen Winkel von 120° einschließen.

Bevorzugt alternativ zu einer Ausführungsform mit gleichmäßig in Umfangsrichtung verteilten Umfangspositionen ist eine Ausführungsform des Vielschichtaktors realisierbar, bei der mindestens zwei unterschiedliche Umfangspositionen in einer gemeinsamen sich in Längsrichtung des Vielschichtaktors erstreckenden Ebene angeordnet sind. Anders ausgedrückt sind die Faltachsen von mindestens zwei benachbarten Umfangspositionen in einer gemeinsamen Ebene angeordnet, wobei sich in einer gemeinsamen Ebene an mindestens zwei nebeneinander angeordneten Positionen Umbiegungsstapel ergeben.

In Weiterbildung der Erfindung ist mit Vorteil vorgesehen, dass der gefaltete Elektrodenstreifen zur Optimierung seiner Robustheit in einer Hülle aus deformierbarem, insbesondere dielektrischem, Material, insbesondere aus Silikon oder Acryl, eingebettet ist.

Im Hinblick auf die Ausbildung des Elektrodenstreifens gibt es unterschiedliche Möglichkeiten. Besonders bevorzugt ist eine Ausführungsform, bei der der Elektrodenstreifen eine mittlere Schicht aus dielektrischem, insbesondere elastisch, deformierbaren Material umfasst, wobei beidseitig auf diese Schicht Elektroden, insbesondere aus einem deformierbaren Material mit elektrisch leitenden Partikeln aufgebracht, insbesondere aufgedruckt, sind. Besonders bevorzugt handelt es sich bei dem Dielektrikum um ein, insbesondere elektroaktives, Polymer, vorzugsweise um ein Elastomer, beispielsweise aus der Gruppe der Silikone und/oder der Acrylate. Besonders bevorzugt umfasst oder besteht das Elastomer aus Silikon und/oder Fluorsilikon und/oder Polyurethan und/oder Polybutadien und/oder Polyacryl und/oder Polytetrafluorethylen und/oder P(VDF-TrFE)-Copolymer und/oder Isopren und/oder Acrylat.

Die Elektroden können beispielsweise durch Drucken, insbesondere Siebdrucken oder Digitaldrucken, eines elektrisch leitenden Materials oder durch Ionen-Implantation auf die Schicht aus deformierbarem Dielektrikum aufgebracht werden.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1:: eine perspektivische Darstellung eines Vielschichtaktors mit wechselnder Faltrichtung,
- Fig. 2:: einen mäanderförmigen Elektrodenstreifen zum Herstellen eines gefalteten Vielschichtaktors mit an mehreren Umfangspositionen realisierten Umbiegungen,
- Fig. 3:: eine alternative Ausführungsform eines mäanderförmigen Elektrodenstreifens,
- Fig. 4:: eine weitere alternative Ausführungsform eines abgewickelten Elektrodenstreifens zum Herstellen eines sechseckig konturierten Vielschichtaktors,
- Fig. 5:: eine weitere alternative Ausführungsform eines abgewickelten Elektrodenstreifens zum Herstellen eines gefalteten Vielschichtaktors, wobei einzelne Elektrodenabschnitte über Stege miteinander verbunden sind, wobei die Elektrodenabschnitte im Wesentlichen kreisförmig konturiert sind,
- Fig. 6:: eine weitere alternative Ausführungsform eines abgewickelten Elektrodenstreifens zur Herstellung eines Vielschichtaktors, bei dem nach jeder Faltung ein Faltrichtungswechsel erfolgt und
- Fig. 7:: eine nicht erfindungsgemäße Ausführung eines Elektrodenstreifens zur Herstellung eines Vielschichtaktors, wobei der Elektrodenstreifen geradlinig ausgeformt ist und jeweils zwei benachbarte Elektrodenabschnitte über einen Steg miteinander verbunden sind, dessen Breitenerstreckung geringer ist als die Breitenerstreckung des Elektrodenstreifens.

### Ausführungsformen der Erfindung

In den Figuren sind gleiche Bauelemente und Bauelemente mit der gleichen Funktion mit den gleichen Bezugszeichen gekennzeichnet.

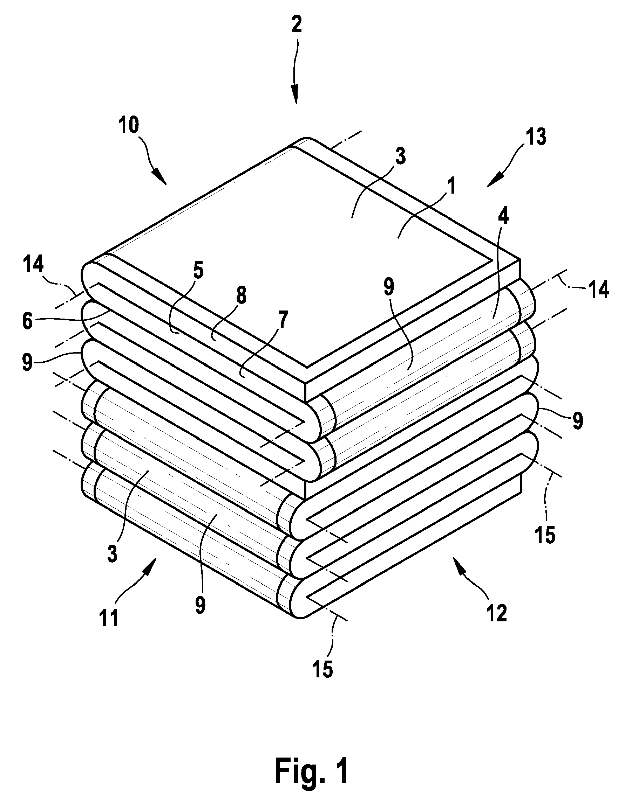

In Fig. 1 ist ein durch Falten eines Elektrodenstreifens 1 hergestellter Vielschichtaktor 2 gezeigt. Der lediglich schematisch angedeutete Elektrodenstreifen 1 besteht aus einer mittleren Schicht 8 aus einem deformierbaren Dielektrikum, auf die beidseitig eine Elektrodenschicht 3, 4 aufgebracht ist. Dabei bestehen die Elektrodenschichten 3, 4 aus einem deformierbaren, elastisch verformbaren, elektrisch leitfähigen Material.

Aus dem beschriebenen Aufbau des Elektrodenstreifens 1 ergibt sich eine Vielschichtaktorstruktur mit einer Vielzahl von nebeneinander (hier übereinander) angeordneten, parallelen Elektrodenabschnitten 5, 6, wobei die Elektrodenabschnitte 5 jeweils durch zwei aneinander anliegende Abschnitte der Elektrodenschicht 4 und die Elektrodenabschnitte 6 durch jeweils zwei unmittelbar aneinander liegende Abschnitte der Elektrodenschicht 3 gebildet sind. Zwischen zwei Elektrodenabschnitten 5 befindet sich jeweils ein deformierbares Dielektrikum 7, das von der mittleren Schicht 8 des Elektrodenstreifens 1 gebildet ist. Wird zwischen die Elektrodenschicht 3, 4 eine elektrische Spannung (Potentialdifferenz) angelegt, kontrahiert der Vielschichtaktor 2 aufgrund der resultierenden elektrostatischen Anziehung jeweils zweier benachbarter Elektrodenabschnitte 5, 6, wobei sich das zwischen zwei Elektrodenabschnitten 5, 6 befindliche Dielektrikum volumenkonstant in die anderen beiden Raumrichtungen ausdehnt.

Wie sich aus Fig. 1 ergibt, verlaufen die Elektrodenabschnitte 5, 6 zumindest in einem zentrischen Bereich parallel zueinander. Randseitig sind durch Falten des Elektrodenstreifens 1 mehrere Umbiegungen 9 realisiert, wobei die Umbiegungen 9 in Fig. 1 aus Übersichtlichkeitsgründen idealisiert, d. h. mit einem minimalen Biegeradius, dargestellt sind. In der Praxis ist der Biegeradius der Umbiegungen 9 etwas größer, so dass sich durch die Stapelung der Umbiegungen 9 in Längsrichtung des Vielschichtaktors 2 eine zusätzliche Materialanhäufung in Randbereichen ergibt.

Um die erwähnte Materialanhäufung in Richtung der Längserstreckung des Vielschichtaktors 2, d. h. in Stapelrichtung, zu minimieren, sind bei dem in Fig. 1 gezeigten Vielschichtaktor 2 die Umbiegungen 9 gleichmäßig in Umfangsrichtung verteilt angeordnet. Dies ist dadurch realisiert, dass an vier gleichmäßig über den Umfang des gefalteten Elektrodenstreifens 1 verteilten Umfangspositionen 10, 11, 12, 13 Umbiegungen 9 angeordnet, d. h. der Elektrodenstreifen 1 an vier Umfangspositionen 10, 11, 12, 13 gefaltet ist.

Bei der in Fig. 1 gezeigten, sehr einfachen Ausgestaltung eines Vielschichtaktors 2 mit einer quadratischen Umfangskontur sind die Faltachsen 14 der in der Zeichnungsebene oberen Umbiegungen 9 rechtwinklig zu den Faltachsen 15 der in der Zeichnungsebene unteren Umbiegungen 9 angeordnet. Es hat also eine Drehung, d. h. ein Wechsel, der quer zu den Faltachsen 14, 15 verlaufenden, nicht eingezeichneten Faltrichtungen nach der Realisierung von jeweils drei Umbiegungen 9 stattgefunden, mit der Folge, dass die Umbiegungen 9 insgesamt gleichmäßig über den Umfang des Vielschichtaktors 2 verteilt angeordnet sind, wobei jeder Seitenfläche des gefalteten Elektrodenstreifens 1 die gleiche Anzahl an Umbiegungen 9 (nämlich drei) zugeordnet sind.

Die Darstellung gemäß Fig. 1 dient lediglich der Erläuterung des Grundprinzips eines gefalteten Vielschichtaktors 2 mit an mehr als zwei Umfangspositionen 10, 11, 12, 13 realisierten Umbiegungen 9. Im Folgenden werden mögliche Ausführungsformen von Elektrodenstreifen 1 zur Herstellung von Vielschichtaktoren 2 erläutert, wobei sich der Aufbau eines aus dem entsprechenden Elektrodenstreifen 1 hergestellten Vielschichtaktors 2 für den Fachmann unmittelbar aus der jeweiligen graphischen Darstellung des Elektrodenstreifens 1 ergibt.

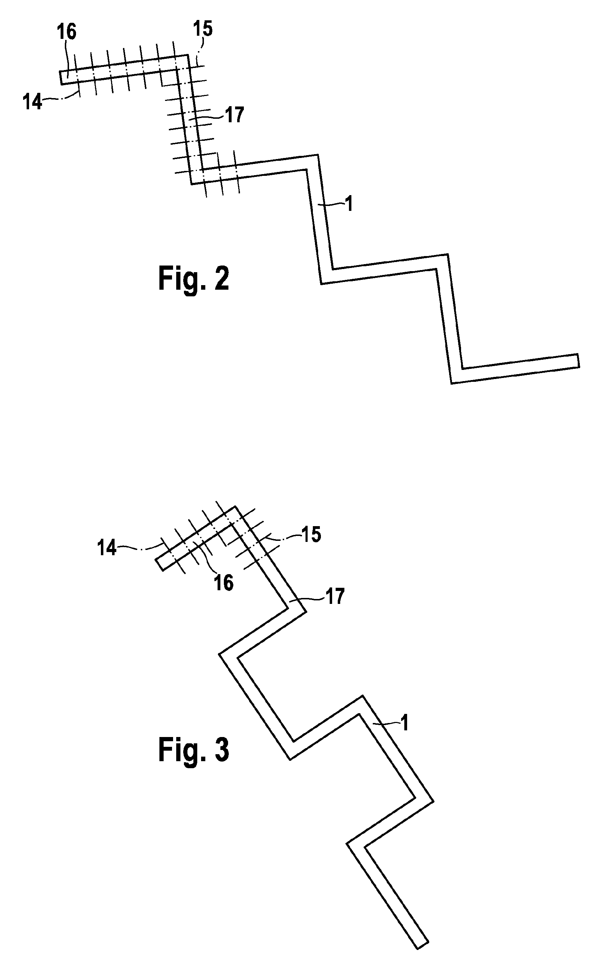

Der Elektrodenstreifen 1 gemäß Fig. 2 weist einen mäanderförmigen Verlauf auf und dient zur Herstellung von Vielschichtaktoren 2 mit quadratischem oder rechteckigem Querschnitt. Im Gegensatz zum Stand der Technik ist die Faltrichtung eines mit einem derartigen Elektrodenstreifen 1 hergestellten Vielschichtaktors 2 nicht immer gleich ausgeführt, sondern die quer zu den Faltachsen 14, 15 verlaufenden Faltrichtungen werden nach jeweils gleicher Zahl von an den Faltachsen 14, 15 realisierten Umbiegungen um 90° gedreht. Die dargestellte Anzahl an Faltachsen 14, 15, nach der eine Drehung der Faltrichtung erfolgt, ist frei wählbar und wird bevorzugt an die Dicke des lediglich schematisch dargestellten Elektrodenstreifens 1 angepasst. Beispielsweise ist ein Wechsel der Faltrichtung bereits nach jeder Schicht möglich. Besonders praktikabel ist jedoch ein Wechsel nach etwa zehn bis fünfzig Umbiegungen.

Wie sich weiter aus Fig. 2 ergibt, weist der Elektrodenstreifen 1 mehrere rechtwinklig zueinander angeordnete Elektrodenstreifenabschnitte 16, 17 auf, wobei die Faltachsen 14, 15 eines jeden Elektrodenstreifenabschnittes 16, 17 parallel zueinander verlaufen; die Faltachsen 14, 15 benachbarter Elektrodenstreifenabschnitte 16, 17 sind jedoch rechtwinklig zueinander angeordnet. Wie sich weiter aus Fig. 2 ergibt, sind die Elektrodenabschnitte 16, 17 in Richtung der Längserstreckung des Elektrodenstreifens 1 betrachtet abwechselnd nach rechts und links zueinander um 90° abgewinkelt.

Im Gegensatz zu dem Elektrodenstreifen 1 gemäß Fig. 2 sind die Elektrodenabschnitte 16, 17 bei dem Elektrodenstreifen 1 gemäß Fig. 3 nicht alternierend nach rechts und links in Längsrichtung des Elektrodenstreifens 1 betrachtet zueinander abgewinkelt angeordnet, sondern ein Wechsel der Orientierungsrichtung erfolgt erst nach jeweils zwei Abwinklungen, so dass sich nicht wie gemäß Fig. 2 ein Sägezahnprofil, sondern ein Nutenprofil mit abwechselnd in die eine und die andere Richtung geöffneten Nutabschnitten ergibt. Zu erkennen ist, dass auch bei dem Ausführungsbeispiel gemäß Fig. 3 die Faltachsen 14, 15 zweier unmittelbar in Längsrichtung des Elektrodenstreifens 1 benachbarter Elektrodenstreifenabschnitte 16, 17 rechtwinklig zueinander angeordnet sind.

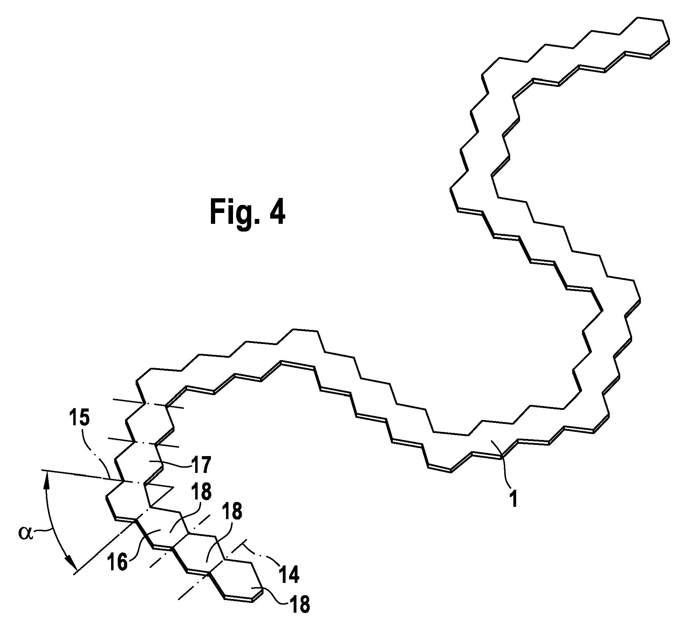

Der Elektrodenstreifen 1 gemäß Fig. 4 dient zur Herstellung eines sechseckig konturierten Vielschichtaktors 2. Zu erkennen ist, dass der Elektrodenstreifen 1 aus einer Vielzahl von sechseckig konturierten Teilabschnitten 18 besteht, wobei zwischen jeweils zwei benachbarten Teilabschnitten 18 eine Faltachse 14, 15 angeordnet ist. Ferner ergibt sich aus Fig. 4, dass die Faltachsen 14, 15 zweier in Richtung der Längserstreckung des Elektrodenstreifens 1 benachbarter, winklig zueinander angeordneter Elektrodenstreifenabschnitte 16, 17 winklig zueinander angeordnet sind. In dem gezeigten Ausführungsbeispiel schließen diese benachbarten Faltachsen 14, 15 einen Winkel α von 60° ein, wohingegen die Faltachsen 14, 15 jedes Elektrodenstreifenabschnittes 16, 17 untereinander parallel angeordnet sind. Wie sich aus Fig. 4 weiter ergibt, erfolgt ein Faltrichtungswechsel nach jeweils drei Umbiegungen. Insgesamt ergibt sich durch die mäanderförmige Strukturierung des Elektrodenstreifens 1 eine gleichmäßige in Umfangsrichtung verteilte Anordnung der Umbiegungen eines fertigen Vielschichtaktors. Dabei ist jeder der sechs Seitenflächen des gefalteten Elektrodenstreifens 1 die gleiche Anzahl an Faltachsen 14, 15 und damit die gleiche Anzahl an Umbiegungen, zugeordnet.

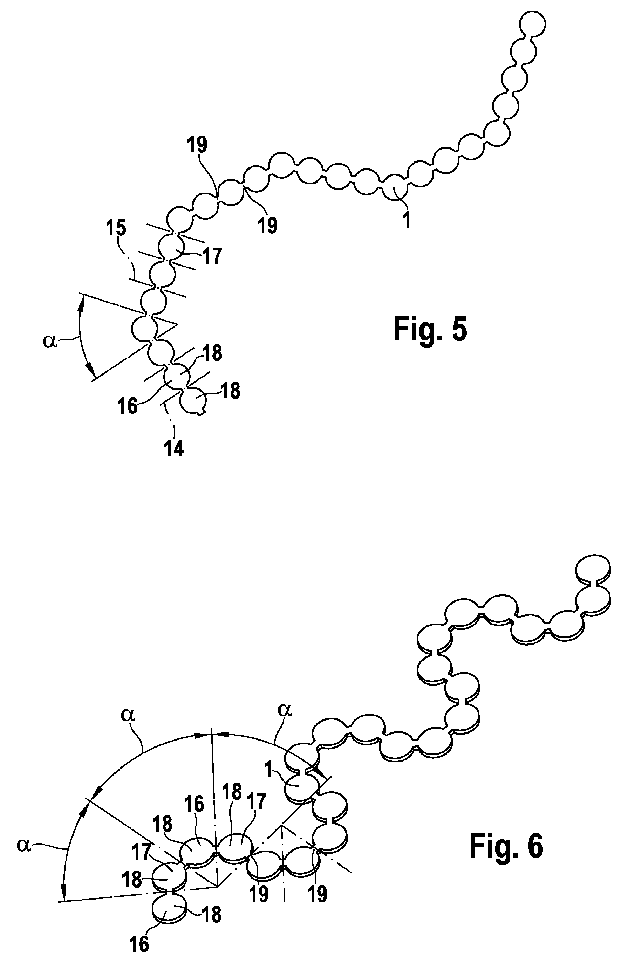

Bei dem Ausführungsbeispiel eines Elektrodenstreifens 1 gemäß Fig. 5 weisen die Faltachsen 14, 15 der relativ zueinander faltbaren Teilabschnitte 18 des Elektrodenstreifens 1 eine kreisrunde Umfangskontur auf. Zu erkennen ist, dass die Faltachsen 14, 15 zweier benachbarter, winklig zueinander angeordneter Elektrodenstreifenabschnitte 16, 17 unter einem Winkel von 60° zueinander verlaufen, wobei die Faltachsen 14, 15 des jeweiligen Elektrodenstreifen-abschnitts 16, 17 parallel zueinander verlaufen. Die Faltachsen 14, 15 verlaufen jeweils mittig und quer durch die die Teilabschnitte 18 miteinander verbindenden Stege 19.

Das in Fig. 6 gezeigte Ausführungsbeispiel eines Elektrodenstreifens 1 entspricht im Wesentlichen dem in Fig. 5 gezeigten Ausführungsbeispiel, mit dem Unterschied, dass ein Faltrichtungswechsel nach jeder Faltung und nicht wie bei dem Ausführungsbeispiel gemäß Fig. 5 nach jeweils vier Faltungen erfolgt. In der Folge besteht jeder Elektrodenstreifenabschnitt 16, 17 aus einem einzigen Teilabschnitt 18 und jeweils zwei benachbarte, durch jeweils einen Steg 19 verlaufende Faltachsen 14, 15 sind unter einem Winkel α von in diesem Ausführungsbeispiel 60° zueinander angeordnet.

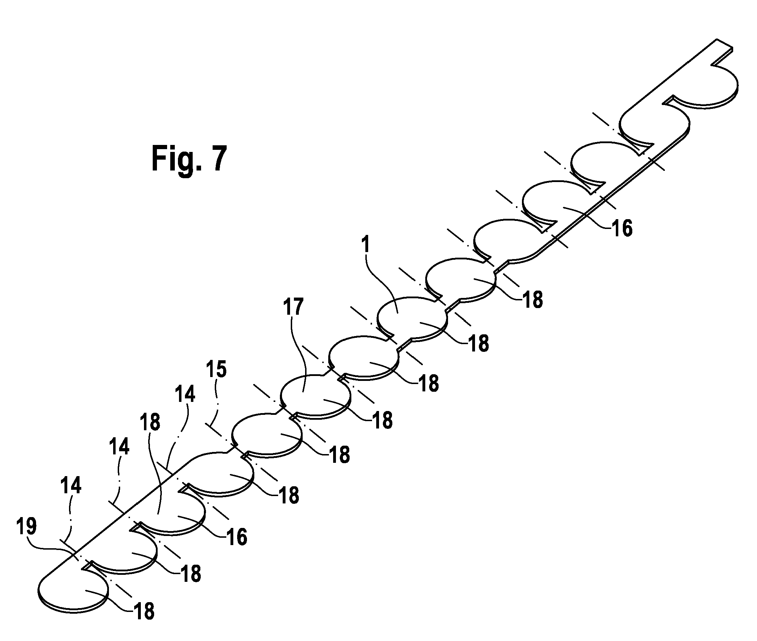

Die nicht erfindungsgemäße Ausführung gemäß Fig. 7 unterscheidet sich in sofern von sämtlichen zuvor beschriebenen Ausführungsbeispielen, als dass die Umfangspositionen, an denen bei einem fertigen Vielschichtaktor Umbiegungen realisiert sind, nicht gleichmäßig in Umfangsrichtung verteilt angeordnet sind.

Der Elektrodenstreifen 1 besteht aus mehreren geradlinigen Elektrodenstreifenabschnitten 16, 17, wobei jeder Elektrodenstreifenabschnitt 16, 17 aus vier flächigen Teilabschnitten 18 zusammengesetzt ist. Jeweils zwei in Richtung der Längserstreckung des Elektrodenstreifens 1 benachbarte Teilabschnitte 18 sind über einen Steg 19 miteinander verbunden, wobei die Breitenerstreckung der Stege 19, also die Erstreckung der Stege 19 quer zur Längserstreckung des Elektrodenstreifens 1, wesentlich geringer ist als die Breitenerstreckung des Elektrodenstreifens 1 bzw. der Teilabschnitte 18. Aus Fig. 7 ist zu erkennen, dass die Position der Stege 19 quer zur Längserstreckung des Elektrodenstreifens 1 betrachtet bei jeweils zwei benachbarten Elektrodenstreifenabschnitten 16, 17 unterschiedlich ist. Beim Wechsel der Stegposition und damit der Umfangsposition, an der bei einem fertigen Vielschichtaktor Umbiegungen realisiert sind, wechselt nach einer gewissen Anzahl von Teilabschnitten 18 bzw. Faltachsen 14, 15 - in dem gezeigten Ausführungsbeispiel findet ein Wechsel der Stegposition quer zur Längserstreckung des Elektrodenstreifens 1 nach vier Teilabschnitten 18 bzw. nach drei Faltungen bzw. drei Faltachsen 14, 15 statt. Die Stegposition 19 wechselt in Richtung der Längserstreckung des Elektrodenstreifens 1 betrachtet von in der Zeichnungsebene links, über zwei unterschiedliche Mittenpositionen bis an eine Position in der Zeichnungsebene rechts. Wie sich aus Fig. 7 ergibt, sind sämtliche Faltachsen 14, 15 des Elektrodenstreifens 1 und damit des fertigen Vielschichtaktors 2 parallel zueinander ausgerichtet.

## Patentansprüche

1. Durch Falten eines Elektrodenstreifens (1) an mehreren unterschiedlichen Umfangspositionen (10, 11, 12, 13) hergestellter Vielschichtaktor (2), mit einer Vielzahl nebeneinander angeordneter Elektrodenabschnitte (5, 6) und mit zwischen zwei benachbarten Elektrodenabschnitten (5, 6) angeordnetem deformierbarem, insbesondere elektroaktivem, Dielektrikum (7), wobei an jeder. Umfangsposition (10, 11, 12, 13) durch Falten mindestens eine Umbiegung (9) gebildet ist,
wobei
der Elektrodenstreifen (1) an mehr als zwei Umfangspositionen (10, 11, 12, 13) gefaltet ist, **dadurch gekennzeichnet, dass** der Elektrodenstreifen (1) vor dem Falten mäanderförmig ausgeformt ist.

2. Vielschichtaktor nach Anspruch 1,
**dadurch gekennzeichnet,**
**dass** die Umfangspositionen (10, 11, 12, 13), zumindest näherungsweise, gleichmäßig in Umfangsrichtung verteilt angeordnet sind.

3. Vielschichtaktor nach einem der Ansprüche 1 oder 2,
**dadurch gekennzeichnet,**
**dass** die Umbiegungen (9), zumindest näherungsweise, gleichmäßig in Umfangsrichtung verteilt angeordnet sind.

4. Vielschichtaktor nach einem der vorhergehenden Ansprüche,
**dadurch gekennzeichnet,**
**dass** ein Wechsel zwischen zwei in Umfangsrichtung benachbarten Umfangspositionen (10, 11, 12, 13) immer nach, zumindest näherungsweise, der gleichen Anzahl von Umbiegungen (9) realisiert ist.

5. Vielschichtaktor nach einem der vorhergehenden Ansprüche,
**dadurch gekennzeichnet,**
**dass** die Umfangskontur des gefalteten Elektrodenstreifens (1) die Form eines, insbesondere punktsymmetrischen, Vieleckes aufweist und dass jeder Seitenfläche des gefalteten Vielschichtaktors (2), zumindest näherungsweise, die gleiche Anzahl von Umbiegungen (9) zugeordnet ist.

6. Vielschichtaktor nach einem der vorhergehenden Ansprüche,
**dadurch gekennzeichnet,**
**dass** jeder Umbiegung (9) eine Faltachse (14, 15) zugeordnet ist, und dass die Faltachsen (14, 15) von an in Umfangsrichtung benachbarten Umfangspositionen (10, 11, 12, 13) angeordneten Umbiegungen (9) einen Winkel (α) aufspannen.

7. Vielschichtaktor nach einem der vorhergehenden Ansprüche,
**dadurch gekennzeichnet,**
**dass** jeweils zwei benachbarte Elektrodenabschnitte (5, 6) des Elektrodenstreifens (1) über jeweils einen Steg (19) miteinander verbunden sind.

8. Vielschichtaktor nach einem der vorhergehenden Ansprüche,
**dadurch gekennzeichnet,**
**dass** jeder Umbiegung (9) eine Faltachse (14, 15) zugeordnet ist, und dass die Faltachsen (14, 15) von mindestens zwei in Umfangsrichtung benachbarten Umbiegungen (9) in einer gemeinsamen Ebene liegen.

9. Vielschichtaktor nach einem der vorhergehenden Ansprüche,
**dadurch gekennzeichnet,**
**dass** der gefaltete Elektrodenstreifen (1) in eine Hülle aus deformierbarem, insbesondere dielektrischem, Material eingebettet ist.

10. Vielschichtaktor nach einem der vorhergehenden Ansprüche,
**dadurch gekennzeichnet, dass** der Elektrodenstreifen (1) eine mittlere Schicht (8) aus dem dielektrischen, deformierbaren Material mit beidseitig aufgebrachten, insbesondere aufgedruckten oder aufgesprühten, Elektrodenschichten (3, 4) aufweist.

## Claims

1. Multilayer actuator (2) produced by folding an electrode strip (1) at a number of different peripheral positions (10, 11, 12, 13), comprising a multiplicity of electrode sections (5, 6) arranged next to one another, and comprising a deformable, in particular electroactive, dielectric (7) arranged between two adjacent electrode sections (5, 6), at least one bend (9) being formed at each peripheral position (10, 11, 12, 13) by folding,
wherein
the electrode strip (1) is folded at more than two peripheral positions (10, 11, 12, 13), **characterized in that**, before the folding, the electrode strip (1) is shaped in a meandering form.

2. Multilayer actuator according to Claim 1,
**characterized**
**in that** the peripheral positions (10, 11, 12, 13) are arranged such that they are, at least approximately, distributed uniformly in the peripheral direction.

3. Multilayer actuator according to either of Claims 1 and 2,
**characterized**
**in that** the bends (9) are arranged such that they are, at least approximately, distributed uniformly in the peripheral direction.

4. Multilayer actuator according to one of the preceding claims,
**characterized**
**in that** a change between two peripheral positions (10, 11, 12, 13) that are adjacent in the peripheral direction is always made after, at least approximately, the same number of bends (9).

5. Multilayer actuator according to one of the preceding claims,
**characterized**
**in that** the peripheral contour of the folded electrode strip (1) has the form of a polygon, in particular a point-symmetric polygon, and in that each side face of the folded multilayer actuator (2) is assigned, at least approximately, the same number of bends (9).

6. Multilayer actuator according to one of the preceding claims,
**characterized**
**in that** each bend (9) is assigned a folding axis (14, 15), and in that the folding axes (14, 15) of bends (9) arranged at peripheral positions (10, 11, 12, 13) that are adjacent in the peripheral direction define an angle (α).

7. Multilayer actuator according to one of the preceding claims,
**characterized**
**in that** each two adjacent electrode sections (5, 6) of the electrode strip (1) are respectively connected to one another by way of a web (19).

8. Multilayer actuator according to one of the preceding claims,
**characterized**
**in that** each bend (9) is assigned a folding axis (14, 15), and in that the folding axes (14, 15) of at least two bends (9) that are adjacent in the peripheral direction lie in a common plane.

9. Multilayer actuator according to one of the preceding claims,
**characterized**
**in that** the folded electrode strip (1) is embedded in an enclosure of deformable, in particular dielectric, material.

10. Multilayer actuator according to one of the preceding claims,
**characterized**
**in that** the electrode strip (1) has a middle layer (8) of the dielectric, deformable material, with electrode layers (3, 4) applied on both sides, in particular printed on or sprayed on.

## Revendications

1. Actionneur multicouche (2) réalisé par pliage d'un ruban d'électrode (1) en plusieurs positions différentes (10, 11, 12, 13) de sa périphérie,
présentant plusieurs sections d'électrode (5, 6) disposées les unes à côté des autres et un diélectrique (7) déformable, en particulier électroactif, disposé entre deux sections d'électrode (5, 6) voisines,
au moins un rabat (9) étant formé en chaque position (10, 11, 12, 13) de la périphérie par pliage,
le ruban d'électrode (1) étant plié en plus de deux positions (10, 11, 12, 13) de sa périphérie, **caractérisé en ce que**
le ruban d'électrode (1) est déformé en méandres avant le pliage.

2. Actionneur multicouche selon la revendication 1, **caractérisé en ce que** les positions périphériques (10, 11, 12, 13) sont disposées au moins approximativement de manière régulière dans la direction périphérique.

3. Actionneur multicouche selon l'une des revendications 1 ou 2, **caractérisé en ce que** les rabats (9) sont disposés au moins approximativement en répartitions régulières dans la direction périphérique.

4. Actionneur multicouche selon l'une des revendications précédentes, **caractérisé en ce qu'**un changement entre deux positions périphériques (10, 11, 12, 13) voisines dans la direction périphérique est toujours réalisé au moins approximativement après le même nombre de rabats (9).

5. Actionneur multicouche selon l'une des revendications précédentes, **caractérisé en ce que** le contour périphérique du ruban d'électrode (1) replié présente la forme d'un quadrilatère en particulier à symétrie ponctuelle et **en ce qu'**au moins approximativement le même nombre de rabats (9) est associé à chaque surface latérale de l'actionneur multicouche (2) plié.

6. Actionneur multicouche selon l'une des revendications précédentes, **caractérisé en ce qu'**à chaque rabat (9) est associé un axe de pliage (14, 15) et **en ce que** les axes de pliage (14, 15) de rabats (9) disposés en des positions périphériques (10, 11, 12, 13) voisines dans la direction périphérique forment un angle (α).

7. Actionneur multicouche selon l'une des revendications précédentes, **caractérisé en ce que** deux sections d'électrode voisines (5, 6) du ruban d'électrode (1) sont reliées l'une à l'autre par l'intermédiaire d'une traverse (19).

8. Actionneur multicouche selon l'une des revendications précédentes, **caractérisé en ce qu'**à chaque rabat (9) est associé un axe de pliage (14, 15) et **en ce que** les axes de pliage (14, 15) d'au moins deux rabats (9) voisins dans la direction périphérique sont situés dans un même plan.

9. Actionneur multicouche selon l'une des revendications précédentes, **caractérisé en ce que** le ruban d'électrode (1) replié est incorporé dans une enveloppe en matériau déformable et en particulier en matériau diélectrique.

10. Actionneur multicouche selon l'une des revendications précédentes, **caractérisé en ce que** le ruban d'électrode (1) présente une couche centrale (8) en le matériau diélectrique déformable, sur les deux côtés duquel sont appliquées des couches d'électrode (3, 4), en particulier par impression ou par pulvérisation.
